# EUROPEAN PATENT APPLICATION

(11) **EP 4 755 580 A1**
(43) Date of publication of application: **10.06.2026**
(21) Application number: 24848797.7
(22) Date of filing: 03.07.2024
(51) Int. Cl.: B24B 53/017, B24B 55/06, H01L 21/304

(54) **CLEANING PROCESS DEVICE**

(30) Priority: 28.07.2023 JP 2023123693
(71) Applicant: Shin-Etsu Handotai Co., Ltd., Tokyo 100-0004 (JP)
(72) Inventor: IGARASHI, Kensaku, Nishishirakawa-gun, Fukushima 961-8061 (JP)
(74) Representative: Schicker, Silvia
(86) International application number: PCT/JP2024/024011
(87) International publication number: WO 2025/028138

(57) **Abstract**

The present invention is a cleaning treatment apparatus 1 including a horn-type ultrasonic generator 5 that propagates ultrasonic waves to a cleaning liquid supplied to a polishing pad 109 of a polishing apparatus 100, the polishing apparatus 100 including a lower turn table 101, a sun gear 105 provided on an inside of the lower turn table 101, and an internal gear 107 provided on an outside of the lower turn table 101, the polishing pad 109 being attached to an upper surface of the lower turn table 101, in which the cleaning treatment apparatus 1 includes a rail 3 that is fixed on the sun gear 105 and the internal gear 107 across the lower turn table 101 and on which the ultrasonic generator 5 is mounted, the ultrasonic generator 5 is able to move on the rail 3, and the ultrasonic generator 5 generates ultrasonic waves by a horn 23 while moving on the rail 3, and performs the ultrasonic cleaning by propagating ultrasonic waves to the polishing pad 109 through the cleaning liquid. Thereby, a cleaning treatment apparatus that allows the ultrasonic cleaning while maintaining the interval between the horn and the polishing pad with high accuracy, even in the case where the horn-type ultrasonic generator is included is provided.

## Description

### TECHNICAL FIELD

The present invention relates to a cleaning treatment apparatus.

### BACKGROUND ART

Generally, in a polishing process for a semiconductor wafer, when the wafer is polished using a polishing pad such as a foamed polyurethane pad, a slurry aggregate and a polishing residue produced from the wafer are accumulated within foamed portions of the polishing pad.

The accumulated substances are gathered in the interior of the polishing pad and are solidified, and thereby, cause the generation of a scratch on a surface of the wafer during the polishing. Moreover, the life of the polishing pad is determined by the deterioration in wafer quality, and there is a problem of the decrease in the life of the polishing pad due to accumulated substances. Therefore, a polishing pad cleaning method allowing accumulated substances to be sufficiently removed from the interior of the polishing pad has been demanded.

Patent Document 1 describes a method in which a polishing pad surface is conditioned by a cleaning in which a cleaning liquid is sprayed toward a polishing pad at high pressure and by using a water-flow-type ultrasonic generator. Moreover, Patent Document 2 describes a method in which a polishing pad surface is cleaned using a horn-type ultrasonic generator.

### CITATION LIST

### PATENT LITERATURE

Patent Document 1: JP 2008-142851 A
Patent Document 2: JP 2003-282506 A

### SUMMARY OF INVENTION

### TECHNICAL PROBLEM

For removing foreign substances adhering on the polishing pad and the interior thereof, the ultrasonic cleaning described in Patent Document 2 is effective, and for maintaining a more effective frequency and output, it is preferable to use a horn-type ultrasonic generator having a frequency of 100 kHz or lower and an amplitude of 10 µm or more.

However, in an apparatus that meets this condition, the housing and the weight are large. In a configuration in which a hand having a distal end equipped with the ultrasonic generator is inserted from the exterior of a turn table as described in Patent Document 1, there are problems in that the stiffness of the hand is insufficient, distortion and vibration are generated, the interval between the polishing pad and the horn of the ultrasonic generator cannot be maintained, and there are problems of a danger of the contact and a matter that an expected cleaning effect cannot be obtained.

The present invention has been made for solving the above problems, and has an object to provide a cleaning treatment apparatus that allows the ultrasonic cleaning while maintaining the interval between the horn and the polishing pad with high accuracy, even in the case where the horn-type ultrasonic generator is included.

### SOLUTION TO PROBLEM

The present invention has been made for achieving the above object, and provides a cleaning treatment apparatus comprising a horn-type ultrasonic generator that propagates ultrasonic waves to a cleaning liquid supplied to a polishing pad of a polishing apparatus and performing ultrasonic cleaning of the polishing pad, the polishing apparatus including a lower turn table, a sun gear provided on an inside of the lower turn table, and an internal gear provided on an outside of the lower turn table, the polishing pad being attached to an upper surface of the lower turn table, wherein the cleaning treatment apparatus comprises a rail that is fixed on the sun gear and the internal gear across the lower turn table and on which the ultrasonic generator is mounted, the ultrasonic generator is able to move on the rail, and the ultrasonic generator generates ultrasonic waves by a horn while moving on the rail, and performs the ultrasonic cleaning by propagating the generated ultrasonic waves to the polishing pad through the cleaning liquid.

In such an ultrasonic generator, the rail is fixed on the sun gear and the internal gear across the lower turn table, and the ultrasonic generator is mounted, so that the ultrasonic generator is held by both of the sun gear and the internal gear through the rail.

Therefore, the stiffness of the rail can be secured compared to a structure such as a cantilever, as exemplified by a hand having a distal end equipped with the ultrasonic generator, and the ultrasonic cleaning can be performed while the interval between the horn and the polishing pad is maintained with high accuracy.

On this occasion, the rail may include gear fixation holes provided on surfaces that contact with the sun gear and the internal gear, and may be fixed to the sun gear and the internal gear through the gear fixation holes.

Thereby, the rail can be fully fixed to the sun gear and the internal gear.

On this occasion, the rail may make it possible to adjust an interval in a height direction between the horn of the ultrasonic generator and the polishing pad, by moving up or down the sun gear or the internal gear.

Thereby, even in the case where the rail or the ultrasonic generator itself has no lifting function of the horn, the horizontality and height of the rail can be adjusted and maintained with high accuracy by adjusting the heights of the sun gear and the internal gear, and the interval between the horn and the polishing pad can be kept constant.

On this occasion, the ultrasonic generator may be able to move on the rail in a sun gear direction or in an internal gear direction in a state where the lower turn table is being rotated.

Thereby, it is possible to perform the ultrasonic cleaning while rotating the turn table and moving the ultrasonic generator in a direction from the center to the outer circumference of the turntable or in the reverse direction, and it is possible to efficiently clean the whole surface of the polishing pad.

On this occasion, a material of the rail may be stainless or titanium.

This makes it easy for the rail to secure a stiffness enough to bear the weight of the ultrasonic generator.

On this occasion, a material of the horn of the ultrasonic generator may be stainless or titanium.

Thereby, the tensile strength of the horn becomes high, and this make it possible to bear high amplitude, so that ultrasonic waves having a high amplitude can be generated.

On this occasion, the cleaning treatment apparatus may comprise a cleaning-liquid supply nozzle through which the cleaning liquid is supplied onto the polishing pad such that a gap between the horn and the polishing pad is water-sealed.

Thereby, at the time of the ultrasonic cleaning, the gap between the horn and the surface of the polishing pad is filled with the cleaning liquid, and the cleaning can be surely performed.

### ADVANTAGEOUS EFFECTS OF INVENTION

As described above, the cleaning treatment apparatus in the present invention allows the ultrasonic cleaning while maintaining the interval between the horn and the polishing pad with high accuracy, even in the case where the horn-type ultrasonic generator is included.

Specifically, although the maintenance of the interval between the ultrasonic generator and the turn table is difficult in a conventional apparatus, the present invention causes the maintenance to be possible with high accuracy, and considerably decreases the possibility of the contact between the turn table and the ultrasonic generator.

Moreover, even an ultrasonic generator having a high weight can be installed, and the horn-type ultrasonic generator can be equipped with a vibrator having a frequency of 100 kHz or lower.

Furthermore, since the possibility of the contact with the turn table is very low, it is possible to perform the ultrasonic cleaning while rotating the turn table and moving the ultrasonic generator in the direction from the center to the outer circumference of the turn table or in the reverse direction.

### BRIEF DESCRIPTION OF DRAWINGS

[FIG. 1] shows a top view of a cleaning treatment apparatus according to an embodiment of the present invention and a polishing apparatus including a polishing pad that is an object to be cleaned by the cleaning treatment apparatus.
[FIG. 2] shows a perspective view of the cleaning treatment apparatus in FIG. 1.
[FIG. 3] shows a side view of a state where the cleaning treatment apparatus is fixed to the polishing apparatus.
[FIG. 4] shows the description of radial distances from an inner circumferential edge of the polishing pad as measurement positions for the interval between a horn and the polishing pad.

### DESCRIPTION OF EMBODIMENTS

The present invention will be described below in detail, but the present invention is not limited to them.

As described above, the cleaning treatment apparatus that allows the ultrasonic cleaning while maintaining the interval between the horn and the polishing pad with high accuracy even in the case where the horn-type ultrasonic generator is included has been desired.

The inventor has performed diligent study about the above problem, and as a result, has completed the present invention, by finding that the ultrasonic cleaning can be performed while the interval between the horn and the polishing pad is maintained with high accuracy even in the case where the horn-type ultrasonic generator is included, by a cleaning treatment apparatus including a horn-type ultrasonic generator that propagates ultrasonic waves to a cleaning liquid supplied to a polishing pad of a polishing apparatus and performing ultrasonic cleaning of the polishing pad, the polishing apparatus including a lower turn table, a sun gear provided on an inside of the lower turn table, and an internal gear provided on an outside of the lower turn table, the polishing pad being attached to an upper surface of the lower turn table, in which the cleaning treatment apparatus includes a rail that is fixed on the sun gear and the internal gear across the lower turn table and on which the ultrasonic generator is mounted, the ultrasonic generator is able to move on the rail, and the ultrasonic generator generates ultrasonic waves by a horn while moving on the rail, and performs the ultrasonic cleaning by propagating the generated ultrasonic waves to the polishing pad through the cleaning liquid.

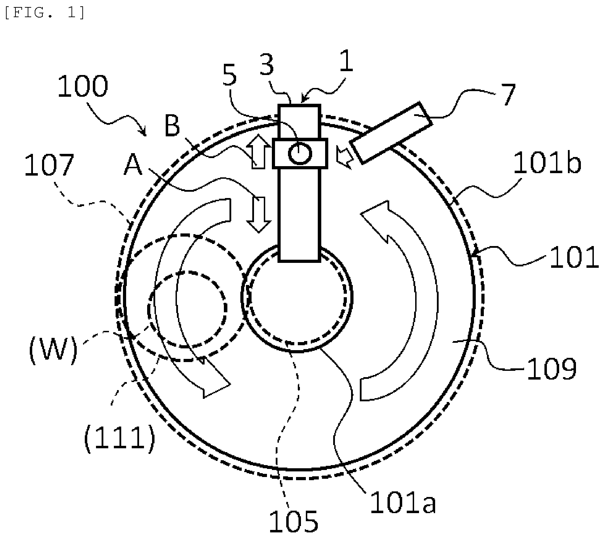

A cleaning treatment apparatus according to an embodiment of the present invention will be described below with reference to FIG. 1 to FIG. 4.

In this embodiment, a cleaning treatment apparatus for a polishing pad equipped in a polishing apparatus for polishing a single crystal semiconductor wafer, particularly, a silicon wafer will be exemplified.

First, a schematic configuration of a polishing apparatus including a polishing pad that is an object to be cleaned in the cleaning treatment apparatus in the embodiment will be described with reference to FIG. 1. As shown in FIG. 1, the polishing apparatus 100 includes a lower turn table 101, a polishing pad 109, a sun gear 105, and an internal gear 107.

The lower turn table 101 is a turn table in which the polishing pad 109 is attached to an upper surface, and has a disk shape that includes a circular hole at the center, in this embodiment. The polishing pad 109 is a member that polishes a silicon wafer W, and for example, is a foamed member such as a foamed polyurethane pad.

The sun gear 105 is a spur gear provided on the inside of an inner circumference 101a of the lower turn table 101, and the internal gear 107 is an internal gear provided on the outside of an outer circumference 101b of the lower turn table 101.

The polishing apparatus 100 causes a spur gear called a carrier 111 to engage with the sun gear 105 and the internal gear 107 and hold the silicon wafer W, rotates the lower turn table 101 around the axis of the disk while supplying a polishing liquid such as slurry to the polishing pad 109, and furthermore, presses the silicon wafer W toward the polishing pad 109, so that a lower surface of the silicon wafer W can be polished.

It is allowable to adopt a configuration in which an upper surface of the silicon wafer W is compressed through an upper turn table to which a polishing pad is attached, at the time of the polishing. In a structure in which the turn tables are provided on both of the upper and lower sides of the carrier 111 in this way, both surfaces of the silicon wafer W can be polished, and therefore, the polishing apparatus 100 serves as a double-side polishing apparatus.

On the other hand, in the case where only the lower turn table 101 is adopted as the turn table and is compressed without polishing the upper surface of the silicon wafer W, only the lower surface of the silicon wafer W can be polished, and therefore, the polishing apparatus 100 serves as a single-side polishing apparatus.

When the silicon wafer W is polished using a foamed polyurethane pad or the like as the polishing pad 109, a slurry aggregate and a polishing residue produced from the silicon wafer W are accumulated within foamed portions of the polishing pad 109.

When the accumulated substances are gathered in the interior of the polishing pad 109 and are solidified, a scratch is sometimes generated on the surface of the silicon wafer W during the polishing, and therefore, it is necessary to clean the polishing pad 109 periodically by flushing the accumulated substances.

Next, the configuration of the cleaning treatment apparatus will be described with reference to FIG. 1 to FIG. 4.

A cleaning treatment apparatus 1 shown in FIG. 1 to FIG. 4 is an apparatus that performs the ultrasonic cleaning of the polishing pad by a horn-type ultrasonic generator 5 while supplying the cleaning liquid to the polishing pad, and includes a rail 3, the ultrasonic generator 5, and a cleaning-liquid supply nozzle 7.

The rail 3 is a member on which the ultrasonic generator 5 is mounted, and is fixed on the sun gear 105 and the internal gear 107 so as to extend in a radial direction between the inner circumference 101a and the outer circumference 101b of the lower turn table 101, as shown in FIG. 1.

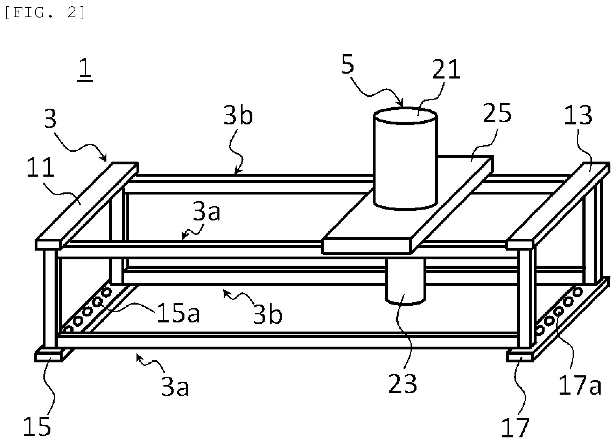

As shown in FIG. 2, the rail 3 includes frame-shaped rail members 3a, 3b, upper-portion coupling members 11, 13, and lower-portion coupling members 15, 17.

The frame-shaped rail members 3a, 3b are rail bodies on which the ultrasonic generator 5 is mounted and that have a rectangular frame shape, the long sides of the rectangular extend in the horizontal direction, in this embodiment, in the radial direction of the lower turn table 101, and the short sides extend in the vertical direction.

Incidentally, the frame-shaped rail members 3a, 3b may be provided with reinforcement members such as braces, in the frames. Moreover, although the rail 3 in FIG. 2 includes two frame-shaped rail members 3a, 3b as a pair, the number of frame-shaped rail members is not limited to two.

The upper-portion coupling members 11, 13 are plate members that couple upper end surfaces in the longitudinal direction of the frame-shaped rail member 3a and the frame-shaped rail member 3b, the upper-portion coupling member 11 couples one ends in the longitudinal direction, and the upper-portion coupling member 13 couples the other ends in the longitudinal direction. Means for joining the upper-portion coupling members 11, 13 and the frame-shaped rail members 3a, 3b is not particularly limited, and the upper-portion coupling members 11, 13 and the frame-shaped rail members 3a, 3b may be fastened by bolts, nuts, and the like, or may be joined by welding and the like.

The lower-portion coupling members 15, 17 are members that couple lower end surfaces in the longitudinal direction of the frame-shaped rail members 3a, 3b, which are positioned at the lower sides so as to face the frame-shaped rail members 3a, 3b at the upper sides, and that include, on lower surfaces, surfaces to contact with the sun gear 105 and the internal gear 107 when the rail 3 is fixed to the sun gear 105 and the internal gear 107. In the following description, a case where the lower surface of the lower-portion coupling member 15 contacts with the sun gear 10 and the lower surface of the lower-portion coupling member 17 contacts with the internal gear 107 will be described as an example.

In FIG. 2, the lower-portion coupling member 15 couples one ends in the longitudinal direction, and the lower-portion coupling member 17 couples the other ends in the longitudinal direction. Means for joining the lower-portion coupling member 15, the lower-portion coupling member 17, and the frame-shaped rail members 3a, 3b is not particularly limited, and the lower-portion coupling member 15, the lower-portion coupling member 17, and the frame-shaped rail members 3a, 3b may be fastened by bolts, nuts, and the like, or may be joined by welding and the like.

It is preferable that the lower-portion coupling members 15, 17 include gear fixation holes 15a, 17a provided on the surfaces that contact with the sun gear 105 and the internal gear 107 as shown in FIG. 2. The gear fixation holes 15a, 17a are holes for fixing the rail 3 to the sun gear 105 and the internal gear 107, and in FIG. 2, through-holes that vertically pass through the lower-portion coupling members 15, 17 are shown as an example.

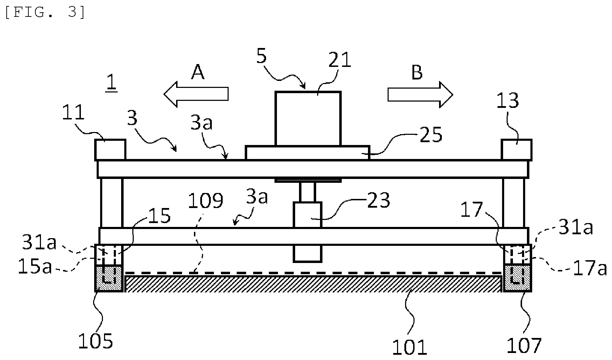

For example, as shown in FIG. 3, the lower-portion coupling members 15, 17 are disposed on the sun gear 105 and the internal gear 107, pins 31a are caused to enter the gear fixation holes 15a, 17a, and furthermore, the pins 31a are inserted into holes provided on the sun gear 105 and the internal gear 107, so that the rail 3 is fully fixed to the sun gear 105 and the internal gear 107 through the gear fixation holes 15a, 17a.

Incidentally, the gear fixation holes 15a, 17a may be female screws in which thread grooves are formed on the insides. In this case, the pins 31a are male screws that are screwed into the gear fixation holes 15a, 17a, as exemplified by bolts.

It is preferable that the material of the frame-shaped rail members 3a, 3b, the upper-portion coupling members 11, 13, and the lower-portion coupling members 15, 17 that constitute the rail 3 is a material having a high stiffness. Specifically, stainless or titanium is preferable because it is easy for the rail 3 to secure a stiffness enough to bear the weight of the ultrasonic generator 5, but resin or the like may be adopted.

The ultrasonic generator 5 is a horn-type ultrasonic generator that propagates ultrasonic waves to the cleaning liquid supplied to the polishing pad 109 of the polishing apparatus 100, and includes a main body 21, a horn 23, and a slide portion 25, as shown in FIG. 2 and FIG. 3.

The main body 21 is a member including a vibrator that vibrates the horn 23, and the like. It is preferable that the frequency of the vibrator is 15 to 100 kHz. The horn 23 is a member that generates ultrasonic waves by being vibrated by the vibrator, and is coupled to the main body 21 so as to be oriented to the polishing pad 109 that is the object to be cleaned. Specifically, in the case where the polishing pad 109 attached to the lower turn table 101 is cleaned, the horn 23 is disposed so as to be oriented downward.

However, the orientation of the horn 23 may be variable. For example, in the case where the polishing apparatus 100 is the double-side polishing apparatus and the polishing pad attached to the upper turn table is also cleaned, the horn 23 may be able to be rotated around an unillustrated horizontal shaft, for example, and thereby, may be able to be disposed so as to be oriented upward toward the polishing pad 109 attached to the upper turn table, by vertically inverting the horn 23 in the state in FIG. 2.

It is preferable that the horn 23 can generate an ultrasonic wave having a high amplitude, and specifically, it is preferable that the horn 23 can apply an ultrasonic wave having an amplitude of 10 µm or more and 40 µm or less.

It is preferable that the material of the horn 23 is a material having a high tensile strength, as exemplified by stainless and titanium, because it is possible to bear an ultrasonic wave having a higher amplitude as the tensile strength is higher. Moreover, in the comparison between stainless and titanium, titanium has an advantage in terms of the level of the tensile strength. Moreover, stainless and titanium are preferable also in that it is hard for stainless and titanium to become impure substances even when stainless and titanium adhere to the polishing pad 109 when the polishing pad 109 is cleaned.

The slide portion 25 is a member that is provided across the frame-shaped rail members 3a, 3b, and is a member that allows the ultrasonic generator 5 to move on the rail 3. Specifically, the slide portion 25 is a member that causes the ultrasonic generator 5 to move by moving on the frame-shaped rail members 3a, 3b in a long side direction, that is, in a sun gear direction A or an internal gear direction B in FIG. 1 and FIG. 3.

In FIG. 2 and FIG. 3, for the simplification of the figures, the slide portion 25 is a member on a flat plate directly placed on the upper surfaces of the frame-shaped rail members 3a, 3b, and slides on the frame-shaped rail members 3a, 3b, so that the ultrasonic generator 5 performs slide movement along the rail 3, but the slide method is not limited to this.

For example, as for the slide method, the slide can be performed by providing bearings, wheels, caterpillars, or the like on the slide portion 25 of the ultrasonic generator 5 or the frame-shaped rail members 3a, 3b of the rail 3. In the case of the wheels, it is preferable that flanges are provided on the outer circumferences of the wheels so as to enter the insides of the frame-shaped rail members 3a, 3b and treads have a cone shape or an arc shape.

Moreover, the slide method may be a manual method or an automatic method. The automatic slide method can include a method in which an axle shaft is rotated by a gear, a method in which a rope or the like is provided on the slide portion 25 of the ultrasonic generator 5 and this rope is pulled, and other methods.

Particularly, it is preferable that the ultrasonic generator 5 is able to move on the rail 3 in the sun gear direction A or the internal gear direction B in a state where the lower turn table 101 is being rotated. By performing the ultrasonic cleaning while rotating the lower turn table 101 and moving the ultrasonic generator 5 in a direction from the center (the inner circumference 101a in FIG. 1) of the lower turn table 101 to the outer circumference 101b or in the reverse direction in this way, it is possible to efficiently clean the whole surface of the polishing pad 109.

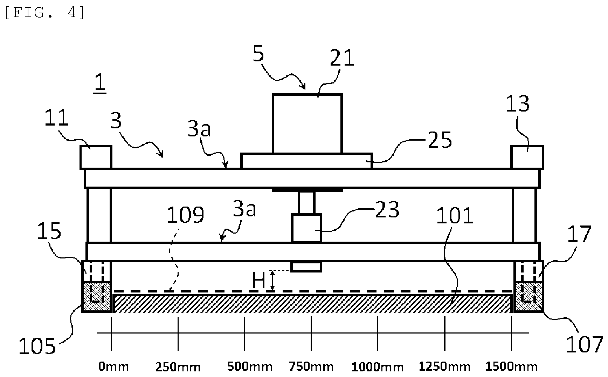

Incidentally, it is preferable that the rail 3 makes it possible to adjust an interval H in a height direction between the horn 23 of the ultrasonic generator 5 and the polishing pad 109 shown in FIG. 4. As such a configuration, for example, the rail 3 may be provided with a mechanism that causes the ultrasonic generator 5 to rise and fall, but it is preferable that the interval H can be adjusted by moving up or down the sun gear 105 or the internal gear 107 and moving up or down the ultrasonic generator 5 together with the rail 3.

In this case, even in the case where the rail 3 or the ultrasonic generator 5 itself has no lifting function of the horn 23, the horizontality and height of the rail 3 can be adjusted and maintained with high accuracy by adjusting the height of the sun gear 105 or the internal gear 107, and the distance (the interval H) between the horn 23 and the polishing pad 109 can be kept constant.

The cleaning-liquid supply nozzle 7 shown in FIG. 1 is a nozzle through which the cleaning water is supplied onto the polishing pad 109. It is preferable that the cleaning-liquid supply nozzle 7 is a nozzle through which the cleaning liquid is supplied onto the polishing pad 109 such that the gap between the horn 23 and the polishing pad 109 is water-sealed. Thereby, at the time of the ultrasonic cleaning, the polishing pad 109 can be cleaned such that the gap between the horn 23 and the surface of the polishing pad 109 is surely filled with the cleaning liquid and ultrasonic waves are propagated to the cleaning liquid. That is, a state where the cleaning liquid level does not reach the horn 23 and ultrasonic waves are not propagated to the cleaning liquid does not occur.

"The gap between the horn 23 and the polishing pad 109 is water-sealed" mentioned here includes not only a case where a distal end of the horn 23 and the polishing pad are sealed with water, but also a case where a liquid other than water is used as the cleaning liquid and the gap between the distal end of the horn and the polishing pad is sealed with the liquid.

The installation position of the cleaning-liquid supply nozzle 7 is not particularly limited as long as the cleaning water can be supplied onto the polishing pad 109, and in order that the gap between the horn 23 and the polishing pad 109 is water-sealed, it is preferable that the cleaning-liquid supply nozzle 7 is installed near the horn 23. Accordingly, it is more preferable to adopt a mechanism in which the cleaning-liquid supply nozzle 7 moves together when the ultrasonic generator 5 moves on the rail 3.

In this way, in the cleaning treatment apparatus 1, the ultrasonic generator 5 can generate ultrasonic waves by the horn 23 while moving on the rail 3, and can perform the ultrasonic cleaning by propagating the generated ultrasonic waves to the polishing pad 109 through the cleaning liquid.

Next, an example of a cleaning method for the polishing pad 109 in which the cleaning treatment apparatus 1 is used will be briefly described.

First, the cleaning treatment apparatus 1 is fixed to the sun gear 105 and the internal gear 107 of the polishing apparatus 100. Furthermore, the horn 23 is oriented to the polishing pad 109 that is the object to be cleaned, and the interval H between the horn 23 and the polishing pad 109 is set. The interval H preferably should have a degree that allows the water seal of the gap between the horn 23 and the polishing pad 109, and specifically is 5 mm or less. Incidentally, the lower limit of the interval H is 0 mm, and the horn 23 may contact with the polishing pad 109.

Next, the cleaning liquid such as pure water or an alkali aqueous solution including ammonia water, KOH, NaOH, and TMAH (tetramethylammonium hydroxide) is supplied from the cleaning-liquid supply nozzle 7, ultrasonic waves are generated from the horn 23 by driving the ultrasonic generator 5 while the gap between the horn 23 and the polishing pad 109 is water-sealed, ultrasonic waves are propagated to the interior of the polishing pad 109 through the cleaning liquid, and cleaning is performed such that accumulated substances are removed.

Incidentally, ultrasonic waves are more easily propagated in liquid, and therefore, when ultrasonic waves are applied after the cleaning liquid permeates the interior of the polishing pad 109, ultrasonic waves are more easily propagated in the cleaning liquid, so that the ability of the removal of accumulated substances in the interior of the polishing pad 109 is enhanced.

At the time of the cleaning, by performing the cleaning while moving the ultrasonic generator 5 on the rail 3 in the sun gear direction A or the internal gear direction B shown in FIG. 1 and FIG. 3 in a state where the lower turn table 101 is being rotated, it is possible to efficiently clean the whole surface of the polishing pad 109.

Incidentally, in the case where the polishing apparatus 100 is the double-side polishing apparatus including the upper turn table, the polishing pad attached to the upper turn table can be also cleaned.

Specifically, the horn 23 is oriented upward toward the polishing pad 109 attached to the upper turn table, the ultrasonic generator 5 is driven while the cleaning liquid is supplied from the cleaning-liquid supply nozzle 7 toward the polishing pad attached to the upper turn table, ultrasonic waves are generated from the horn 23 while the gap between the horn 23 and the polishing pad 109 is water-sealed, ultrasonic waves are propagated to the interior of the polishing pad 109 through the cleaning liquid, and cleaning is performed such that accumulated substances are removed.

At this time, the cleaning liquid flows down from the polishing pad 109 under its own weight, but the interval between the horn 23 and the polishing pad 109 is set to a degree that allows the gap between the horn 23 and the polishing pad 109 to be water-sealed by the surface tension of the cleaning liquid, so that the water seal can be maintained by the surface tension of the cleaning liquid even when the cleaning liquid flows down.

Incidentally, in the case where the cleaning liquid is pure water, the interval that allows the water seal to be maintained by the surface tension is 5 mm or less, regardless of whether the horn 23 is oriented upward or downward.

### EXAMPLE

The present invention will be specifically described below with examples, but they do not limit the present invention.

### (Example)

The cleaning treatment apparatus 1 shown in FIG. 1 to FIG. 4 was fixed to the polishing apparatus 100, and the cleaning of the polishing pad 109 attached to the lower turn table 101 was attempted.

Specifically, first, the cleaning treatment apparatus 1 including the rail 3 made of stainless and including the horn 23 made of titanium as the ultrasonic generator 5 was prepared. In this rail 3, the lower-portion coupling members 15, 17 included the gear fixation holes 15a, 17a.

Next, the rail 3 of the prepared cleaning treatment apparatus 1 was fixed to the sun gear 105 and the internal gear 107 of the polishing apparatus 100 through the gear fixation holes 15a, 17a. The radial length of the polishing pad 109 of the polishing apparatus 100 was 1500 mm, and the material was a foamed polyurethane pad.

Furthermore, in a state where the distal end of the horn 23 was oriented to the polishing pad 109, the sun gear 105 and the internal gear 107 were caused to rise and fall, such that the distance (the interval H) between the polishing pad 109 and the horn 23 became target distances of 1 mm, 3 mm, and 5 mm, and while ultrasonic waves were generated in this state, the distance (the interval H) was actually measured with each 250 mm in a measurement position range of 0 mm to 1500 mm.

The result is shown in Table 1. Incidentally, "Measurement Position" in Table 1 shows the radial distance from the inner circumferential edge of the polishing pad 109 when the position of the inner circumferential edge of the polishing pad 109 on the side of the sun gear 105 is 0 mm.

**[Table 1]**

| | | Measurement Position | | | | | | |
|---|---|---|---|---|---|---|---|---|
| | | 0mm | 250mm | 500mm | 750mm | 1000mm | 1250mm | 1500mm |
| Target Distance between Horn and Polishing pad | 1mm | ±0mm | ±0mm | ±0mm | ±0mm | ±0mm | ±0mm | ±0mm |
| | 3mm | ±0mm | ±0mm | ±0mm | ±0mm | ±0mm | ±0mm | ±0mm |
| | 5mm | ±0mm | ±0mm | ±0mm | ±0mm | ±0mm | ±0mm | ±0mm |

As shown in Table 1, as for each target distance, the actual measurement values of the distance (the interval H) coincide with the target distance, and it has been found that the distance (the interval H) between the horn 23 and the polishing pad 109 can be kept constant in a state where the cleaning treatment apparatus 1 is fixed to the polishing apparatus 100.

Next, the distance (the interval H) between the polishing pad 109 and the horn 23 was set to a target distance of 3 mm, the ultrasonic generator 5 was driven while pure water having a temperature of 25°C was supplied to the polishing pad 109 as the cleaning liquid, and ultrasonic waves were generated from the horn 23 while the gap between the horn 23 and the polishing pad 109 was water-sealed. The amplitude of the ultrasonic wave was 20 µm, and the frequency of the vibrator of the ultrasonic generator 5 was 40 kHz.

Furthermore, the ultrasonic generator 5 was manually slid on the rail 3 while the lower turn table 101 was being rotated counterclockwise, and the ultrasonic cleaning of the whole surface of the polishing pad 109 was performed.

After the ultrasonic cleaning, the reduction degree of accumulated substances in the interior of the polishing pad 109 was checked, and whether the accumulated substance removal effect was exerted was evaluated.

As a result, the removal effect for accumulated substances was exerted, and the surface of the polishing pad 109 was not damaged.

### (Comparative Example)

The ultrasonic generator 5 used in the example was equipped at a hand made of stainless, so as to be held above the polishing pad 109 of the polishing apparatus 100, but the distance (the interval H) between the polishing pad 109 and the horn 23 could not be kept constant because the stiffness of the hand was insufficient.

As described above, in the example of the present invention, even in the case where the horn-type ultrasonic generator 5 was included, the cleaning treatment apparatus 1 could efficiently perform the ultrasonic cleaning of the polishing pad 109 while maintaining the interval H between the horn 23 and the polishing pad 109 with high accuracy.

The present description includes the following embodiments.
[1]: A cleaning treatment apparatus comprising a horn-type ultrasonic generator that propagates ultrasonic waves to a cleaning liquid supplied to a polishing pad of a polishing apparatus and performing ultrasonic cleaning of the polishing pad, the polishing apparatus including a lower turn table, a sun gear provided on an inside of the lower turn table, and an internal gear provided on an outside of the lower turn table, the polishing pad being attached to an upper surface of the lower turn table, wherein
   the cleaning treatment apparatus comprises a rail that is fixed on the sun gear and the internal gear across the lower turn table and on which the ultrasonic generator is mounted,
   the ultrasonic generator is able to move on the rail, and
   the ultrasonic generator generates ultrasonic waves by a horn while moving on the rail, and performs the ultrasonic cleaning by propagating the generated ultrasonic waves to the polishing pad through the cleaning liquid.
[2]: The cleaning treatment apparatus according to [1], wherein
   the rail includes gear fixation holes provided on surfaces that contact with the sun gear and the internal gear, and is fixed to the sun gear and the internal gear through the gear fixation holes.
[3]: The cleaning treatment apparatus according to [1] or [2], wherein
   the rail makes it possible to adjust an interval in a height direction between the horn of the ultrasonic generator and the polishing pad, by moving up or down the sun gear or the internal gear.
[4]: The cleaning treatment apparatus according to any one of [1] to [3], wherein
   the ultrasonic generator is able to move on the rail in a sun gear direction or in an internal gear direction in a state where the lower turn table is being rotated.
[5]: The cleaning treatment apparatus according to any one of [1] to [4], wherein a material of the rail is stainless or titanium.
[6]: The cleaning treatment apparatus according to any one of [1] to [5], wherein a material of the horn of the ultrasonic generator is stainless or titanium.
[7]: The cleaning treatment apparatus according to any one of [1] to [6], comprising a cleaning-liquid supply nozzle through which the cleaning liquid is supplied onto the polishing pad such that a gap between the horn and the polishing pad is water-sealed.

Note that the present invention is not limited to the above embodiment. The above embodiment has been shown as an example, and all embodiments each of which has substantially the same configuration as the technical idea described in the claims in the present invention and has similar function effects are included in the technical scope of the present invention.

## Claims

1. A cleaning treatment apparatus comprising a horn-type ultrasonic generator that propagates ultrasonic waves to a cleaning liquid supplied to a polishing pad of a polishing apparatus and performing ultrasonic cleaning of the polishing pad, the polishing apparatus including a lower turn table, a sun gear provided on an inside of the lower turn table, and an internal gear provided on an outside of the lower turn table, the polishing pad being attached to an upper surface of the lower turn table, wherein
the cleaning treatment apparatus comprises a rail that is fixed on the sun gear and the internal gear across the lower turn table and on which the ultrasonic generator is mounted,
the ultrasonic generator is able to move on the rail, and
the ultrasonic generator generates ultrasonic waves by a horn while moving on the rail, and performs the ultrasonic cleaning by propagating the generated ultrasonic waves to the polishing pad through the cleaning liquid.

2. The cleaning treatment apparatus according to claim 1, wherein
the rail includes gear fixation holes provided on surfaces that contact with the sun gear and the internal gear, and is fixed to the sun gear and the internal gear through the gear fixation holes.

3. The cleaning treatment apparatus according to claim 1, wherein
the rail makes it possible to adjust an interval in a height direction between the horn of the ultrasonic generator and the polishing pad, by moving up or down the sun gear or the internal gear.

4. The cleaning treatment apparatus according to any one of claims 1 to 3, wherein
the ultrasonic generator is able to move on the rail in a sun gear direction or in an internal gear direction in a state where the lower turn table is being rotated.

5. The cleaning treatment apparatus according to claim 1, wherein a material of the rail is stainless or titanium.

6. The cleaning treatment apparatus according to claim 1, wherein a material of the horn of the ultrasonic generator is stainless or titanium.

7. The cleaning treatment apparatus according to claim 1, comprising a cleaning-liquid supply nozzle through which the cleaning liquid is supplied onto the polishing pad such that a gap between the horn and the polishing pad is water-sealed.
